# EUROPÄISCHE PATENTSCHRIFT

(11) **EP 1 459 301 B1**
(45) Veröffentlichungstag und Bekanntmachung des Hinweises auf die Patenterteilung: **16.03.2011**
(21) Anmeldenummer: 02805346.0
(22) Anmeldetag: 20.12.2002
(51) Int. Cl.: G11B 7/00, G11B 7/24, G03C 1/73, G11B 20/10, G11C 13/04

(54) **OPTISCHER DATENSPEICHER UND VERFAHREN ZUR SPEICHERUNG VON DATEN IN EINEM OPTISCHEN DATENSPEICHER**
OPTICAL DATA STORE AND METHOD FOR STORAGE OF DATA IN AN OPTICAL DATA STORE
MEMOIRE DE DONNEES OPTIQUE ET PROCEDE DE STOCKAGE DE DONNEES DANS UNE MEMOIRE DE DONNEES OPTIQUE

(30) Priorität: 21.12.2001 DE 10163428
(43) Veröffentlichungstag der Anmeldung: 22.09.2004
(73) Patentinhaber: Actilor GmbH, 06237 Leuna (DE)
(72) Erfinder: Actilor GmbH, 06237 Leuna (DE)
(74) Vertreter: Tiesmeyer, Johannes
(86) Internationale Anmeldenummer: PCT/EP2002/014681
(87) Internationale Veröffentlichungsnummer: WO 2003/054863

(56) Entgegenhaltungen:
- EP-A- 1 063 645
- WO-A-94/05008
- DE-A- 19 914 702
- US-A- 5 228 001
- "QUARTERLY REVIEWS OF BIOPHYSICS, CAMBRIDGE UNIVERSITY PRESS, LONDON, GB" QUARTERLY REVIEWS OF BIOPHYSICS, CAMBRIDGE UNIVERSITY PRESS, LONDON, GB, Bd. 24, Nr. 4, November 1991 (1991-11), Seiten 425-478, XP002119796 ISSN: 0033-5835
- HAMPP N: "BACTERIORHODOPSIN AS A PHOTOCHROMIC RETINAL PROTEIN FOR OPTICAL MEMORIES" CHEMICAL REVIEWS, AMERICAN CHEMICAL SOCIETY. EASTON, US, Bd. 100, Nr. 5, 2000, Seiten 1755-1776, XP000929839 ISSN: 0009-2665
- XIAODI TAN ET AL.: "Secure optical memory system with polarisation encryption" APPLIED OPTICS, Bd. 40, Nr. 14, 10. Mai 2001 (2001-05-10), Seiten 2310-2315, XP002247016

## Beschreibung

Die Erfindung betrifft einen optischen Datenspeicher sowie ein Verfahren zur Speicherung von Daten in einem solchen optischen Datenspeicher.

Auf dem technischen Gebiet der Informationsverarbeitung wächst die Bedeutung der optischen Datenspeicherung, wie dies am Beispiel der CD-R demonstriert werden kann. Bei Dokumenten, z.B. Kreditkarten usw., wird als Speichermedium üblicherweise ein Magnetstreifen verwendet. Vermehrt kommen auch Speicherchips in Plastikkarten zum Einsatz. Auch sind bereits Geldkarten oder dgl. mit einem optischen Speichermedium bekannt geworden.

Ein Nachteil zahlreicher bekannter Speichermedien liegt darin, dass sie teils keine besonders hohe Speicherkapazität haben oder/und aus Materialien hergestellt sind, die nach Ausmusterung der Datenspeicher Entsorgungsprobleme bereiten.

Es sind auch bereits optische Datenspeicher bekannt geworden, welche als lichtempfindliches Material für die Datenspeicherschicht Bakteriorhodopsin enthalten. So sind z.B. in der WO 94/05008A Zubereitungen von Bakteriorhodopsin-Varianten mit erhöhter Speicherzeit und deren Verwendung für die reversible optische Informationsaufzeichnung offenbart. Diese Zubereitungen enthalten Purpurmembran-Varianten, bei denen Bakteriorhodopsin durch Bestrahlen mit Licht einer Wellenlänge im Bereich der Absorptionsbande des Ausgangszustandes zu mehr als 50 % in ein Fotoprodukt mit einem gegenüber dem Ausgangszustand um mindestens 10 nm spektral verschobenem Absorptionsmaximum überführt wird, wobei das Fotoprodukt durch Bestrahlen mit Licht einer Wellenlänge im Bereich seiner Absorptionsbande in den Ausgangszustand zurück konvertiert werden kann. Mit derartigen Zubereitungen realisierte optische Datenspeicher können daher mit Licht einer Wellenlänge im Bereich der Absorptionsbande des Ausgangszustandes (Schreiblicht) mit Daten beschrieben werden, wobei diese Daten mit Licht einer Wellenlänge im Bereich der Absorptionsbande des Fotoproduktes (Löschlicht) wieder gelöscht werden können. Die Stabilität der eingeschriebenen Daten, d.h. die Stabilität des Speicherungszustandes hängt insbesondere auch davon ab, ob die lichtempfindliche Datenspeicherschicht gegenüber Löschlicht abgeschirmt ist.

Ein solcher löschbarer, d.h. reversibler Speicher mit einer Datenspeicherschicht aus Bakteriorhodopsin in einer Polymermatrix ist auch in der Veröffentlichung "Some methods for irreversible write-once recording in 'Biochrom' films" Vsevolodov; Djukova; Druzhko, Inst. of Biol. Phys., Acad. of Sci., Pushchino; USSR Images of the Twenty-First Century. Proceedings of the Annual International Conference of the IEEE Engineering in Medicine and Biology Society (Cat. No. 89CH2770-6), 9-12 Nov. 1989, Seattle, WA, USA. Informationsaufzeichnung erfolgt bei diesem bekannten reversiblen Datenspeicher mit gelbem Schreiblicht. Das Löschen der Daten erfolgt mittels blauem Löschlicht.

Der vorliegenden Erfindung liegt die Aufgabe zugrunde, einen optischen Datenspeicher anzugeben, der eine Datenaufzeichnung mit einfachen Mitteln und eine sehr stabile Langzeitspeicherung solcher Daten ermöglicht und ferner ohne besonderen Aufwand umweltfreundlich entsorgt werden kann.

Zur Lösung dieser Aufgabe wird erfindungsgemäß ein optischer Datenspeicher vorgeschlagen, der eine Datenspeicherschicht aufweist, die aus einem lichtempfindlichen organischen oder biologischen Polymer gebildet ist, welches ungiftig und biologisch abbaubar ist und immobilisiertes Bakteriorhodopsin in einer Variante enthält, die eine gegenüber dem Wildtyp verlängerte K-Lebensdauer hat, wobei die Datenspeicherschicht nicht-reversible fotoinduzierbare Anisotropie aufweist, zu deren Induktion ein Schwellwert der optischen Intensität übeschritten werden muss.

Das als lichtempfindliches Material mit fotoinduzierbarer permanenter Anisotropie für optische Datenspeicher nach der vorliegenden Erfindung verwendbare Bakteriorhodopsin ist ein kristallines Retinalprotein das in Halobakterien vorkommt. Auf Grund seiner ungewöhnlichen photochemischen Eigenschaften und der Tatsache, dass dieses Protein eine erstaunliche Stabilität gegenüber thermischer und chemischer Zerstörung aufweist, beschäftigt sich die Wissenschaft schon eine ganze Weile mit der Möglichkeit dieses Material, bevorzugt in der Optik, technisch einzusetzen. Wie in der Beschreibungseinleitung unter Bezugnahme auf den Stand der Technik angedeutet, ist es vor einiger Zeit gelungen ein erstes Gerät auf Basis von BR zu entwickeln, bei dem es, eingebettet in dünne Kunststofffilme, als Kurzzeitspeicher für optische Informationen dient. Seit mehr als einem Jahrzehnt besteht die Bemühung, eine Speicherung von Daten für längere Zeit zu etablieren. Dies ist mit der vorliegenden Erfindung nunmehr gelungen. Das Bakteriorhodopsin liegt vorzugsweise in Purpurmembranform vor und ist in der Speicherschicht durch Matrixeinbettung oder Quervernetzung immobilisiert. Dabei findet als lichtempfindliches Material eine Bakteriorhodopsin-Variante Verwendung, die eine gegenüber dem Wildtyp verlängerte K-Lebensdauer aufweist. Dies erlaubt eine Absenkung der Schwellenenergie für die optische Intensität, die zur Erreichung der Anisotropie überschritten werden muss.

Die vorliegende Erfindung führt von der Praxis weg, dass als Speichermedium giftige bzw. unter Entsorgungsgesichtspunkten bedenkliche Materialien benutzt werden. Als Speichermedium nach der Erfindung wird ein ungiftiges und biologisch abbaubares, organisches bzw. biologisches Polymer verwendet, welches beispielsweise durch ein herkömmliches Auftragsverfahren, wie etwa Drucken, Sprühen, Gießen, Tintenstrahl-Auftragen oder dgl., auf ein Trägersubstrat, z.B. Papier, dauerhaft aufgebracht werden kann. Dabei entsteht eine Datenspeicherschicht oder ein Film, in dem das fotoaktive Polymer Bakteriorhodopsin immobilisiert ist. Durch Lichteinwirkung mit einer optischen Intensität, die den Schwellwert überschreitet, kann der Effekt der fotoinduzierten Anisotropie hervorgerufen werden, d.h. die Absorption und/oder der Brechungsindex werden richtungsabhängig. Dieser Effekt ist unter Normalbedingungen nichtreversibel und eignet sich daher für die dauerhafte Speicherung von Informationen. Da für den Datenspeichervorgang eine Intensitätsschwelle überschritten werden muss, die normalerweise nur mit einem Laser erreichbar ist, kann der optische Speicher ohne weiteres dem Tageslicht ausgesetzt werden, ohne dass der Speicherinhalt geändert wird, und zwar auch dann, wenn im Falle photochromen Materials eine Farbänderung des Speichers hervorgerufen wird. Der Speicher nach der Erfindung ist in einer bevorzugten Ausführungsform ein WORM-Speicher. In Prototypen des Speichers wurde schon eine Speicherdichte von mehr als 1 MBit Daten auf einer Fläche von 6 cm² erreicht. Eine Steigerung um mehrere Größenordnungen ist bei Bedarf möglich.

Eine Ausführungsform des Speichers nutzt ein Bakteriorhodopsin mit verlängerter Lebensdauer des sogenannten M-Zustandes. Dadurch wird die ausgeprägte, in der Regel mit bloßem Auge detektierbare Photochromie des Bakteriorhodopsins mit der hier beschriebenen Verwendung als optischer Datenspeicher kombiniert. Optional kann mit blauem Licht oberhalb eines Schwellwertes der Intensität auch der M-Zustand für die Datenspeicherung genutzt werden.

Die hier angegebene Kombination der konventionellen Photochromie geeigneter Bakteriorhodopsine und die Möglichkeit zur Datenspeicherung ist vorteilhaft, um z.B. in Terminals das Auffinden eines solchen Datenspeichers auf einem Dokument zu erleichtern. Aus einem Bildvergleich vor und nach Belichten mit einer für den Speichervorgang nicht ausreichenden Intensität wird der photochrome Bereich durch Differenzbildung der beiden Bilder identifiziert.

Als besonders geeignet und vergleichsweise ökonomisch beschaffbar hat sich Bakteriorhodopsin in Purpurmembranform erwiesen. BR kommt in der Natur als kristallines Protein in Form sogenannter Purpurmembranen vor. Diese Membranblätter sind nur etwa fünf Nanometer dick, was 1/100 einer Lichtwellenlänge entspricht, haben eine unregelmäßige Form und sind durchschnittlich 500 bis 1000 nm im Durchmesser. In dieser Form ist BR so stabil, dass es sogar bei weit über 100 °C heißlaminiert werden kann.

Ferner kommt eine Bakteriorhodopsin-Variante mit einer Mutation in der Retinalbindungsstelle in Frage, so dass das Retinal nicht mehr gebunden ist. Dies reduziert die Bildung von Retroretinalen, die in geringen Mengen entstehen, insbesondere bei erheblicher Überschreitung der Schwellenintensität.

Gemäß einer Ausführungsform der Erfindung umfasst das lichtempfindliche Material eine Bakteriorhodopsin-Variante, bei der das natürliche Retinalmolekül durch eine synthetische Variante ersetzt ist. Dadurch lassen sich . Verschiebungen in der optimalen Wellenlänge für die Datenaufzeichnung erreichen.

Bei einer weiteren Ausführungsform umfasst das lichtempfindliche Material eine Bakteriorhodopsin-Variante, die durch eine sie kennzeichnende Aminosäuresequenz identifiziert werden kann. Diese Aminosäuresequenz ist ein Sicherheitsmerkmal, welches zur Codierung bestimmter Informationen benutzt werden kann. Dadurch kann z.B. eine Produktionscharge des Materials identifiziert werden, was bei Anwendungen im Sicherheitsbereich, z.B. bei Pässen etc., von Bedeutung ist/sein kann.

Die Speicherung von Daten in der Datenspeicherschicht erfolgt vorzugsweise mit Licht unterschiedlicher Polarisationszustände, um die flexiblen

Möglichkeiten der fotoinduzierbaren Anisotropie der Datenspeicherschicht erschöpfend nutzen zu können. So können binäre Daten mit Licht zweier unterschiedlicher Polarisationszustände, insbesondere mit linear polarisiertem Licht aufgezeichnet werden. Zweckmäßigerweise nutzt man als unterschiedliche Polarisationszustände aufeinander senkrecht stehende Polarisationsrichtungen linear polarisierten Lichtes. Als Aufzeichnungslichtquelle kommt vorzugsweise ein gepulster Laser zum Einsatz, der in der Lage ist, das Aufzeichnungslicht mit einer den Schwellwert überschreitenden optischen Intensität bereitzustellen.

Das Auslesen der gespeicherten Informationen erfolgt zweckmäßigerweise mit polarisationsselektiven optischen Mitteln und einem Licht, welches eine wesentlich geringere optische Intensität hat als das Aufzeichnungslicht.

Der optische Datenspeicher kann ein zumindest bereichsweise transparentes und in einem transparenten Bereich die Datenspeicherschicht tragendes Substrat aufweisen, wenn das spätere Auslesen von Daten mit einer optischen Durchlicht-Anordnung und somit unter den Bedingungen der Durchstrahlung der Speicherschicht erfolgen soll.

Gemäß einer bevorzugten Ausführungsform ist die Speicherschicht auf einem diffus reflektierenden Substrat oder Substratbereich, z.B. Papier, Kunststoff oder dgl., aufgebracht. Der Lesevorgang wird bei solchen Datenspeichern vorzugsweise mit Licht innerhalb der Absorptionsbanden des lichtempfindlichen Materials, also des Bakteriorhodopsins, durchgeführt, um die aufgrund der Reflexion des Leselichtes an dem Substrat ganz oder teilweise verloren gegangenen Polarisationseigenschaften kompensieren zu können.

Gemäß einer weiteren Ausführungsform der Erfindung ist zwischen Speicherschicht und Substrat eine spiegelnde Schicht angebracht. Um das Auslesen in Reflexion verbessern zu können, ist es vorteilhaft, eine Spiegelschicht hinter der Speicherschicht anzubringen. Dies kann z.B. durch Bedampfen eines Polymerfilms mit Metall erfolgen. Dieser Polymerfilm mit seiner Metallbedampfung kann ggf. eine weitere Funktion aufweisen. Er kann selbst ebenfalls als optischer Speicher verwendet werden, der aber nicht anisotrop ist.

Der optische Datenspeicher nach der Erfindung kann z.B. in Dokumente integriert werden, etwa in Ausweise, Kreditkarten usw., und auf einfachste Weise, etwa durch Aufdrucken, appliziert werden.

Ein weiterer Aspekt liegt darin, dass das lichtempfindliche Material der Speicherschicht in einem Matrixmaterial eingebettet sein kann, dessen Erweichungspunkt unterhalb der Zerstörungsschwelle der Speicherschicht liegt und das zum Löschen der gespeicherten Information über den Erweichungspunkt erhitzt werden kann, z.B. mittels IR-Strahlung oder Mikrowellenstrahlung. Das Aufweichen des Matrixmaterials beeinflusst die Speicherschicht so, dass vorher eingespeicherte Informationen so diffus "verschwimmen", dass sie nicht mehr interpretierbar sind. Es liegt somit ein Löschvorgang vor. Der optische Datenspeicher kann danach noch mehrmals wieder in der oben angedeuteten Weise unter Ausnutzung der fotoinduzierbaren Anisotropie beschrieben und gelöscht werden.

Soll diese Möglichkeit nicht gegeben sein, so kann bei einem optischen Datenspeicher nach der Erfindung das lichtempfindliche Material in einem Matrixmaterial eingebettet sein, dessen Erweichungspunkt oberhalb der Zerstörschwelle der Speicherschicht liegt. Das Erhitzen des Datenspeichers bis zum Erweichungspunkt des Matrixmaterials führt dann automatisch zur Zerstörung der Speicherschicht. Eine Manipulation der ursprünglich eingespeicherten Daten im Sinne einer Fälschung kann somit nicht erfolgen.

Gegenstand der Erfindung ist auch ein Verfahren zur dauerhaften Speicherung von Daten unter Verwendung eines optischen Datenspeichers gemäß Anspruch 1

Besondere Bedeutung im Rahmen der vorliegenden Erfindung kommt einem Verfahren zur Speicherung von Daten und deren Verschlüsselung in einem Datenspeicher zu, wobei der Datenspeicher vorzugsweise im oben beschriebenen Sinne als Speichermedium ein lichtempfindliches Material mit fotoinduzierbarer Anisotropie aufweist, zu deren Induktion ein Schwellwert der optischen Intensität überschritten werden muss. Bei dem Verfahren werden binäre Daten mit Licht zweier unterschiedlicher Polarisationszustände, insbesondere linear polarisiertem Licht, bevorzugt zueinander senkrecht linear polarisiertem Licht, aufgezeichnet, wobei ein erster Datensatz mit einem zweiten Datensatz ganz oder teilweise überschrieben wird und damit der erste Datensatz verschlüsselt wird.

Dieses Verschlüsselungsverfahren wird nachstehend unter Bezugnahme auf die folgende Tabelle 1 näher erläutert.

**Tabelle 1**

| Schreib- und Verschlüsselungsvorgang | | | | | | | | | |
|---|---|---|---|---|---|---|---|---|---|
| 1. Datensatz | 1 | 0 | 1 | 1 | 0 | 1 | 0 | 0 | 1 |
| Schreibpolarisationen | ↑ | → | ↑ | ↑ | → | ↑ | → | → | ↑ |
| 2. Datensatz | 1 | 1 | 0 | 1 | 1 | 0 | 0 | 1 | 1 |
| Schreibpolarisationen | ↑ | ↑ | → | ↑ | ↑ | → | → | ↑ | ↑ |
| resultierende Information | ↑ | | | ↑ | | | | → | ↑ |

| | | | | | | | | | |
|---|---|---|---|---|---|---|---|---|---|
| Lese- und Dekodierungsvorgang (unauthorisiert) | | | | | | | | | |
| Lesen der Daten | ↑ | | | ↑ | | | → | | ↑ |
| Interpretation ohne Schlüssel (*1) | 1 | ? | ? | 1 | ? | ? | 0 | ? | 1 |

| | | | | | | | | | |
|---|---|---|---|---|---|---|---|---|---|
| Lese- und Dekodierungsvorgang (authorisiert) | | | | | | | | | |
| Lesen der Daten | ↑ | | | ↑ | | | → | | ↑ |
| Interpretation ohne Schlüssel | 1 | ? | ? | 1 | ? | ? | 0 | ? | 1 |
| Schlüssel anwenden (2. Datensatz) | 1 | 1 | 0 | 1 | 1 | 0 | 0 | 1 | 1 |
| Entschlüsselte Information (1. Datensatz) | 1 | 0 | 1 | 1 | 0 | 1 | 0 | 0 | 1 |

| | | | | | | | | | |
|---|---|---|---|---|---|---|---|---|---|
| *15 Bit, die unbekannt sind, ergeben bereits 2⁵ Möglichkeiten = 32. Es ist leicht zu sehen, dass mit steigender Schlüssellänge der Code eine beliebige Komplexität annehmen kann. | | | | | | | | | |

Es wird eine Definition getroffen, z.B. derart, dass die Binärzahl 1 durch eine Schreibpolarisation "↑" und die Binärzahl 0 durch eine Schreibpolarisation "→" repräsentiert wird.

Ein erster Datensatz, repräsentiert durch eine Binärzahlfolge, wird mit Licht, das eine ausreichende Intensität besitzt, unter Anwendung der getroffenen Polarisationzuordnung in dem Datenspeicher gespeichert. Anschließend wird ein zweiter Datensatz, bitweise an den gleichen Stellen gespeichert wie der erste Datensatz, d.h. der erste Datensatz wird mit dem zweiten Datensatz überschrieben ohne jedoch dabei den ersten Datensatz zu löschen. An jedem Speicherort stehen nun die Information, die aus den Schreibvorgängen für den ersten und den zweiten Schreibvorgang resultieren, superponiert und sind untrennbar. Weiter ist auch nicht identifizierbar, welche Information aus dem ersten und welche aus dem zweiten Schreibvorgang resultierte. An allen Orten an denen der erste und der zweite Datensatz identische Werte haben, d.h. 0 oder 1, ist der zugehörige Zahlenwert erkennbar, da beide Datensätze den gleichen Wert an dieser Stelle aufweisen. An allen Orten an denen der erste und der zweite Datensatz unterschiedliche Werte haben, d.h. 0 und 1, ist der zugehörige Zahlenwert nicht mehr erkennbar. Da an einem derartigen Speicherort mit zwei zueinander orthogonalen Polarisationen eine Information geschrieben wurde, ist zwar erkennbar dass dort eine Information steht (dies resultiert aus den einhergehenden Absorptionsänderungen des BR) es ist jedoch nicht identifizierbar ob zum ersten Datensatz die 0 oder die 1 gehört. Der erste Datensatz verschlüsselt also den zweiten Datensatz und umgekehrt. Nur derjenige, der in Besitz der Information für einen der beiden Datensätze ist, kann den anderen Datensatz auslesen. Dies ergibt sich aus der Tatsache, dass man an jedem Ort, der sowohl eine 1 und eine 0 enthält, dann die jeweils richtige Information erhalten kann, wenn man einen der beiden Datensätze kennt, da dann der Wert des anderen Datensatzes an dieser Stelle der komplementäre Wert ist. Die beiden Datensätze (erster und zweiter) sind gleichberechtigt. Es lassen sich somit Daten verschlüsseln, und der Schlüssel kann genauso lang wie die gespeicherten Daten selbst sein. Dies ist ein prinzipieller Vorteil gegenüber Verschlüsselungsverfahren, bei denen nur eine kurze Codierungssequenz verwendet wird, z.B. der PIN-Code von IC-enthaltenden Karten. Wenn der PIN-Code bekannt wurde, steht die gesamte Information zur Verfügung. Im beanspruchten Falle kann selbst bei einer teilweisen Aufdeckung des Schlüssels, z.B. des zweiten Datensatzes, nur die zur bekanntgewordenen Stelle korrespondierende Information gelesen werden. In einer anderen Ausführungsform können für unterschiedliche Bereiche der Information unterschiedliche Schlüssel festgelegt werden. Diese könnten blockweise oder aber auch hierarchisch strukturiert sein. Ein Beispiel dafür könnten z.B. Patientendaten des Speicherinhabers sein. Alle Personenidentifizierenden und für einen im Notfall behandelnden Arzt unbedingt notwendigen Informationen, z.B. derzeit eingenommene Medikamente, Blutgruppe, Allergien etc., könnten ohne Verschlüsselung abgelegt werden. Weitergehende Daten, z.B. einzelne Untersuchungsbefunde, Röntgenbilder etc., könnten durch Verschlüsselung geschützt werden. Diese Daten sind erst dann zugänglich, wenn der Inhaber des Speichers die Informationen zur Entschlüsselung offenbart. Es werden dann wiederum nur die Informationen lesbar, die mit diesem Schlüssel codiert wurden. Auf dem gleichen Speicher gespeicherte andere Daten, z.B. Bankkonten etc., würden dem behandelnden Arzt nicht zugänglich, da für diese Informationen ein weiterer Schlüssel nötig ist.

Dieses Verfahren nach der Erfindung kann auch benutzt werden, um Daten, die ohne Verschlüsselung aufgezeichnet wurden, zu löschen, das heißt unlesbar zu machen. Ist dies das Ziel, würde man jeden Speicherort mit der zur gespeicherten Information komplementären Information überschreiben und damit an allen Orten die Anisotropie zerstören. Damit kann keine Information mehr ausgelesen werden, es kann nur festgestellt werden, dass dieser Ort beschrieben worden ist.

Besondere Bedeutung im Rahmen der Erfindung kommt auch einem Verfahren zur Speicherung von Daten in einem optischen Datenspeicher der oben erläuterten Art zu, wobei der Datenspeicher als lichtempfindliches Speichermedium das Bakteriorhodopsin aufweist, das fotoinduzierte Anisotropie zeigt, zu deren Induktion ein Schwellwert der optischen Intensität überschritten werden muss. Eine wesentliche Besonderheit des Verfahrens liegt darin, dass man beim Aufzeichnen von Daten in der Speicherschicht mehr als zwei unterschiedliche Polarisationszustände pro Speicherort verwendet. Dies erlaubt eine wesentliche Erhöhung der Informationsdichte in der Speicherschicht bzw. einer "Grauwert"-Abstufung. Hierzu folgende Anmerkungen:

Das unbeschriebene Speichermedium ist optisch im Wesentlichen isotrop. Für jede Polarisationrichtung des Schreiblichtes stehen an ein- und derselben Stelle Chromophore zur Verfügung. Es ist also möglich, an zwei benachbarten Stellen Schreiblicht unterschiedlicher Polarisationszustände zu verwenden, z.B. linear polarisiertes Licht unterschiedlicher Orientierung, und erhält an beiden Stellen eine Informationsaufzeichnung, aber mit unterschiedlicher Orientierung der Anisotropie. Die verschiedenen Winkel der induzierten Anisotropie können zur Repräsentation von Information benutzt werden. Dies erlaubt die Darstellung nicht nur einer Binärzahl an einem Speicherort, sondern die Repräsentation einer komplexen bzw. größerwertigen Zahl. An Hand eines Beispiels soll dies erläutert werden.

Gespeichert werden soll die Hexadezimal-Zahlenfolge 8A3C02F7. Jeder Hexadezimalzahl wird ein Speicherort zugewiesen. Die Polarisationsrichtung des Schreiblichtes an den einzelnen Speicherstellen wird entsprechend der nachfolgenden Tabelle 2 eingestellt.

**Tabelle 2**

| | | | | | | | | | | | | | | | | |
|---|---|---|---|---|---|---|---|---|---|---|---|---|---|---|---|---|
| Hexadez.- Zahl | 0 | 1 | 2 | 3 | 4 | 5 | 6 | 7 | 8 | 9 | A | B | C | D | E | F |
| Winkel *¹ [deg] | 0 | 6 | 12 | 18 | 24 | 30 | 36 | 42 | 48 | 54 | 60 | 66 | 72 | 78 | 84 | 90 |

| | | | | | | | | | | | | | | | | |
|---|---|---|---|---|---|---|---|---|---|---|---|---|---|---|---|---|
| *1 Der Winkel bezieht sich auf eine beliebig zu definierende Nullposition. | | | | | | | | | | | | | | | | |

Es ergibt sich somit für die Speicherung der angegebenen Hexadezimalzahl folgende Repräsentation:

**Tabelle 3**

| | | | | | | | | |
|---|---|---|---|---|---|---|---|---|
| Hexadez.- Zahlenfolge | 8 | A | 3 | C | 0 | 2 | F | 7 |
| Winkel | 48 | 60 | 18 | 72 | 0 | 12 | 90 | 42 |

Die Einstellung der Polarisationrichtung des bevorzugt linear polarisierten Schreiblichtes kann z.B. über eine drehbar gelagerte Lambda/2-Platte durchgeführt werden.

Beim Lesen der Information werden die Orte aufgesucht, auf denen geschrieben wurde, dann die Achse der Anisotropie bestimmt und daraus unter Anwendung der oben beschriebenen Regeln die Information rekonstruiert.

Auf diese Weise kann an einer Speicherstelle mehr als ein Informationsbit (Multiplexing) gespeichert werden, z.B. eine Hexadezimalzahl, Grauwerte etc.

Weiter können auf diese Art und Weise Halbtonbilder in den Datenspeicher gespeichert werden, die als sogenannte Grauwertbilder mit Hilfe eines Polarisationsfilters direkt beobachtet werden können. Zu jedem Grauwert wird eine Polarisationsrichtung festgelegt, die bei Betrachtung (Durchstrahlung) des Datenspeichers mit vorzugsweise linear polarisiertem Licht den korrespondierenden Helligkeitswert ergeben.

Unter einem weiteren Aspekt betrifft die Erfindung ein Verfahren zur parallelen Aufzeichnung von Datenblöcken in einem optischen Datenspeicher der oben erläuterten Art, welcher als Speichermedium ein lichtempfindliches Material aufweist, das fotoinduzierte Anisotropie aufweist, zu deren Induktion ein Schwellwert der optischen Intensität überschritten werden muss. Das Verfahren ist dadurch gekennzeichnet, dass das Aufzeichnungslicht nach Maßgabe des jeweils aufzuzeichnenden Datenblockes, insbesondere mit einem steuerbaren Flächenlichtmodulator (FLM) moduliert - und das modulierte Aufzeichnungslicht zum optischen Datenspeicher hin so stark fokussiert wird, dass seine Intensität in der Speicherschicht die zum Aufzeichnen erforderliche Intensitätsschwelle überschreitet.

In Bezug auf den Datenspeicher nach der Erfindung und auf die Möglichkeit der Aufzeichnung von Daten mittels unterschiedlicher Polarisationszustände des Lichtes ist als weiterer Vorteil zu betonen, dass der Datenspeicher vor der Aufzeichnung nicht formatiert werden muss. Hierzu folgende Erläuterung:

Wenn die 0 bei einem Datenspeicher dadurch repräsentiert wird, dass er nicht verändert wurde, so muß der Datenspeicher formatiert werden, damit zwischen einem Ort, der durch die Herstellung im Ursprungszustand ist, und einem Ort, der deshalb im Ursprungszustand ist, weil dies eine Information darstellt, z.B. eine 0, unterschieden werden kann. Zu diesem Zweck werden konventionelle optische Datenspeicher formatiert, d.h. mit einem Muster beschrieben, welches dem Datenspeicher eine Organisation seiner Speicherbereiche aufprägt. Wenn hohe Speicherdichten erreicht werden sollen, müssen diese Strukturen entsprechend detailliert sein. Sobald ein Lese- bzw. Schreibgerät eingesetzt werden soll, muß es auf diese feinen Strukturen einjustiert werden, also entsprechend präzise sein. Dies bedingt einen entsprechenden technischen Aufwand und damit korrespondierende hohe Kosten.

Bei dem Speicher nach der Erfindung kann jede Informationsaufzeichnung, also auch die der 0, durch einen Schreibvorgang und eine korrespondierende Änderung des Speichermediums repräsentiert werden. Damit kann beim Lesevorgang ohne Vorinformation erkannt werden, welche Bereiche Daten enthalten.

Ganz allgemein ist noch hinzuzufügen, dass bei der Speicherung von Daten in den Datenspeicher nach der Erfindung eine Verbesserung der Effizienz, also eine Erniedrigung der benötigten Lichtmenge, erreicht werden kann, wenn die Speicherschicht zum Einschreiben der Daten kurzfristig abgekühlt wird. Danach kann die Temperatur wieder erhöht werden.

Bisher wurde der Speichervorgang in einem Zusammenhang mit Benutzung von polarisiertem Licht beschrieben. In einer weniger bevorzugten Variante der Erfindung kann alternativ mit nicht polarisiertem Licht aufgezeichnet werden, was jedoch nur eine Binärdatenverarbeitung ermöglicht und im Übrigen nicht den oben erläuterten Verschlüsselungsmechanismus erlaubt.

Einige Aspekte der Erfindung werden im Folgenden unter Bezugnahme auf die Figuren näher erläutert.
- Fig. 1: zeigt einen experimentellen Aufbau zum Speichern und Lesen von Informationen in einem optischen Datenspeicher nach der Erfindung bzw. zum Nachweis des Funktionsprinzips der Erfindung und zur Analyse der thermisch stabilen, fotoinduzierten Anisotropie in der Datenspeicherschicht (hier ein Bakteriorhodopsin-Film).
- Fig. 2: zeigt einen optischen Aufbau zur parallelen Aufzeichnung von Datenblöcken in einem optischen Datenspeicher nach der Erfindung.

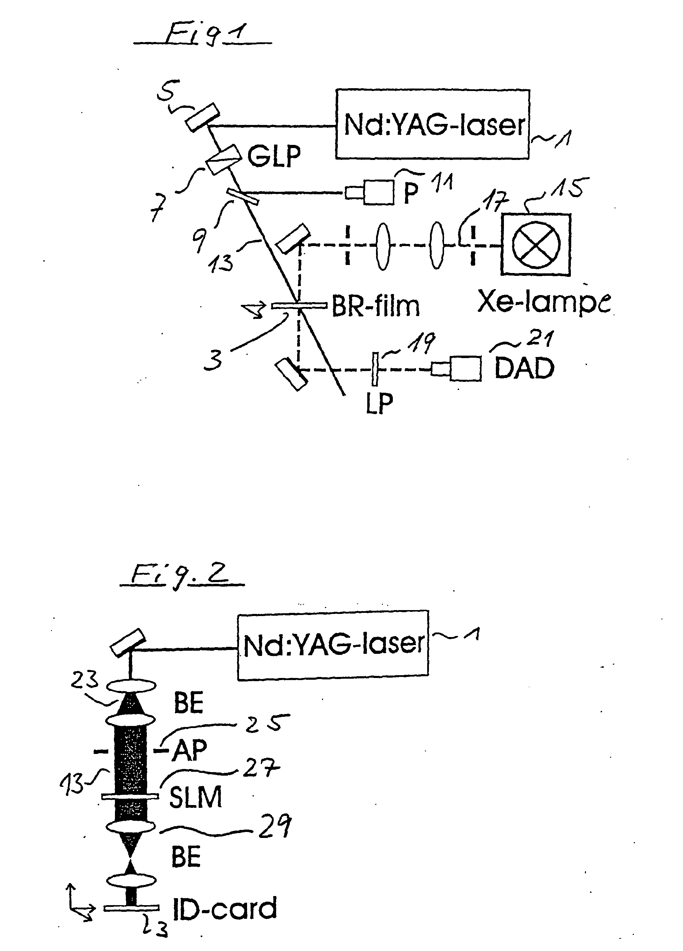

In Fig. 1 ist als Aufzeichnungslichtquelle ein frequenzverdoppelter Nd:YAG-Laser 1 vorgesehen, der Lichtimpulse von etwa 3 ns Dauer emittiert, deren Intensität ausreicht, um den Schwellwert zur Induktion der fotoinduzierbaren Anisotropie der Speicherschicht 3 (hier Bakteriorhodopsin-Film) zu überschreiten. Das Laserlicht durchläuft nach Ablenkung am Spiegel 5 einen Polarisator 7, welcher eine präzise lineare Polarisation des Laserlichtes sicherstellt. Mittels dem Strahlteiler 9 wird ein Teilstrahl ausgekoppelt, um die Laserleistung mit dem Leistungsmessgerät 11 zu messen. Diese Leistungsmessung ist eine experimentelle Maßnahme. Der den Strahlteiler 9 durchlaufende Hauptstrahl 13 des Lasers tritt durch die Speicherschicht 3 hindurch und bewirkt an der Durchtrittsstelle den Effekt der fotoinduzierten Anisotropie des lichtempfindlichen Materials der Speicherschicht 3. Der durch die Speicherschicht 3 repräsentierte optische Datenspeicher kann in zwei Dimensionen relativ zu der Richtung des Hauptstrahls 13 verschoben werden, um wahlweise unterschiedliche Speicherstellen der Speicherschicht zu adressieren. Alternativ könnte dies auch durch einen den Hauptstrahl 13 gesteuert ablenkenden Scanner erfolgen.

Zur Überwachung der spektralen Änderungen in der Speicherschicht bzw. zum Auslesen der geschriebenen Daten ist in dem experimentellen Aufbau gemäß Fig. 1 eine Breitband-Lichtquelle, nämlich eine kollimierte Xenonlampe 15, vorgesehen, deren Strahl 17 unter einem kleinen Winkel zu dem Laserstrahl 13 verlaufend durch die Speicherschicht 3 hindurchtritt und danach durch den Linearpolarisator 19 hindurch zu einem Diodenarraydetektor 21 (Datenlesedetektor) gelenkt wird. Der Linearpolarisator 19 dient zur Auswahl des parallel zur Polarisierung des Laserstrahls 13 polarisierten oder des senkrecht zur Polarisation des Laserstrahls 13 polarisierten Ausleselichtes der Xenonlampe 15. Der experimentelle Aufbau nach Fig. 1 eignet sich in der dargestellten Version zur seriellen Speicherung von Daten in der Speicherschicht 3.

Fig. 2 zeigt einen optischen Aufbau zur parallelen Aufzeichnung bzw. Speicherung von Datenblöcken in einer Speicherschicht 3 eines optischen Datenspeichers nach der Erfindung. Der Strahl des gepulsten Nd:YAG-Lasers 1 wird unter Verwendung einer Strahl aufweitenden optischen Einrichtung 23 aufgeweitet. Der aufgeweitete Strahl 13 tritt durch eine Blende 25 hindurch und wird dann durch einen Flächenlichtmodulator 27 hindurch zu einer fokussierenden optischen Einrichtung 29 geführt. Der Flächenlichtmodulator 27 stellt eine steuerbare "Lichtventilmatrix" dar, bei der es sich beispielsweise um eine Flüssigkristallmatrix mit z.B. 320 x 264 Pixeln handeln kann. Der Modulator 27 moduliert also den aufgeweiteten und daher pro Flächeneinheit relativ geringe Intensität aufweisenden Strahl 13 nach Maßgabe des aktuell parallel zu speichernden Datenblocks. Entsprechend den binären Zuständen der zu speichernden Datenbits erfolgt durch den Modulator 27 eine Einstellung der Polarisationszustände. Vermittels der fokussierenden Optik 29 wird der modulierte Strahl dann zu der Speicherschicht 3 hin fokussiert, so dass dort ein entsprechender Pixelabstand von z.B. 10 µm erreicht wird. Aufgrund der Fokussierung erreicht der Strahl 13 in der Speicherschicht an den Stellen der Belichtung eine Intensität, welche den Schwellwert zur Auslösung der fotoinduzierten Anisotropie überschreitet, so dass der Datenschreibvorgang erfolgen kann.

## Patentansprüche

1. Optischer Datenspeicher mit einer Datenspeicherschicht aus einem lichtempfindlichen organischen oder biologischen Polymer, das ungiftig und biologisch abbaubar ist und immobilisiertes Bakteriorhodopsin in einer Variante enthält, die eine gegenüber dem Wildtyp verlängerte K-Lebensdauer hat, wobei die Datenspeicherschicht nicht-reversible fotoinduzierbare Anisotropie aufweist, zu deren Induktion ein Schwellwert der optischen Intensität überschritten werden muss.

2. Optischer Datenspeicher nach Anspruch 1, wobei das Bakteriorhodopsin in Purpurmembranform vorliegt und in der Speicherschicht durch Matrixeinbettung oder Quervernetzung immobilisiert ist.

3. Optischer Datenspeicher nach Anspruch 1 oder 2, wobei die Datenspeicherschicht eine Bakteriorhodopsin-Variante mit einer Mutation in der Retinalbindungsstelle enthält, so dass das Retinal nicht mehr gebunden ist.

4. Optischer Datenspeicher nach einem der Ansprüche 1 bis 3, wobei die Datenspeicherschicht eine Bakteriorhodopsin-Variante enthält, bei der das natürliche Retinalmolekül durch eine synthetische Variante ersetzt ist.

5. Optischer Datenspeicher nach einem der Ansprüche 1 bis 4, wobei die Datenspeicherschicht eine Bakteriorhodopsin-Variante enthält, die durch eine sie kennzeichnende Aminosäuresequenz identifiziert werden kann.

6. Optischer Datenspeicher nach einem der vorhergehenden Ansprüche, wobei die Speicherschicht auf einem transparenten Substrat aufgebracht ist.

7. Optischer Datenspeicher nach einem der Ansprüche 1 bis 6 mit einer durch ein Auftragsverfahren, insbesondere Drucken, Sprühen oder Gießen hergestellten Speicherschicht.

8. Verfahren zur dauerhaften Speicherung von Daten unter Verwendung eines optischen Datenspeichers gemäß Anspruch 1

9. Verfahren nach Anspruch 8, wobei die Speicherung von Daten in der Datenspeicherschicht mit polarisiertem Licht unterschiedlicher Polarisationszustände erfolgt.

## Claims

1. An optical data store with a data storage layer comprising a light-sensitive organic or biological polymer which is non-toxic and biologically degradable and contains immobilised bacteriorhodopsin in a variant which has prolonged K-lifetime in relation to the Wild type, wherein the data storage layer exhibits non-reversible photoinducible anisotropy, for the induction of which a threshold value of the optical intensity has to be exceeded.

2. An optical data store according to Claim 1, wherein the bacteriorhodopsin is present in purple membrane form and is immobilised in the storage layer by matrix embedding or cross-linking.

3. An optical data store according to Claim 1 or 2, wherein the data storage layer contains a bacteriorhodopsin variant with a mutation in the retinal binding site so that the retinal is no longer bound.

4. An optical data store according to any one of Claims 1 to 3, wherein the data storage layer contains a bacteriorhodopsin variant in which the natural retinal molecule is replaced by a synthetic variant.

5. An optical data store according to any one of Claims 1 to 4, wherein the data storage layer contains a bacteriorhodopsin variant which can be identified by an amino acid sequence which labels it.

6. An optical data store according to any one of the preceding Claims, wherein the data storage layer is applied to a transparent substrate.

7. An optical data store according to any one of Claims 1 to 6 with a storage layer produced by an application process, in particular printing, spraying or pouring.

8. A method for the permanent storage of data using an optical data store according to Claim 1.

9. A method according to Claim 8, wherein the storage of data in the data storage layer is effected with polarised light having different states of polarisation.

## Revendications

1. Mémoire de données optiques comprenant une couche mémoire de données à base d'un polymère organique ou biologique sensible à la lumière, qui n'est pas toxique et est biodégradable et contient de la bactériorhodopsine immobilisée dans une variante, qui a une durée de vie K prolongée par rapport au type sauvage, la couche mémoire de données présentant de l'anisotropie non réversible et photo-inductible, pour l'induction de laquelle une valeur seuil de l'intensité optique doit être dépassée.

2. Mémoire de données optiques selon la revendication 1, la bactériorhodopsine se présentant sous forme d'une forme de membrane de pourpre et étant immobilisée dans la couche mémoire par intégration matricielle et réticulation transversale.

3. Mémoire de données optiques selon la revendication 1 ou 2, la couche mémoire de données contenant une variante de bactériorhodopsine avec une mutation au point de liaison de rétinal, de sorte que le rétinal n'est plus lié.

4. Mémoire de données optiques selon l'une quelconque des revendications 1 à 3, la couche mémoire de données contenant une variante de bactériorhodopsine, dans laquelle la molécule de rétinal naturelle est remplacée par une variante synthétique.

5. Mémoire de données optiques selon l'une quelconque des revendications 1 à 4, la couche mémoire de données contenant une variante de bactériorhodopsine, qui peut être identifiée par une séquence d'aminoacide qui la caractérise.

6. Mémoire de données optiques selon l'une quelconque des revendications précédentes, la couche mémoire étant appliquée sur un substrat transparent.

7. Mémoire de données optiques selon l'une quelconque des revendications 1 à 6 dotée d'une couche mémoire fabriquée par un procédé d'application, en particulier impression, pulvérisation ou coulée.

8. Procédé pour le stockage permanent de données avec l'utilisation d'une mémoire de données optiques selon la revendication 1.

9. Procédé selon la revendication 8, le stockage de données s'effectuant dans la couche mémoire de données avec de la lumière polarisée d'états de polarisation différents.
